(19) Europäisches Patentamt
European Patent Office
Office européen des brevets

(11) **EP 3 054 029 B1**

(12) **EUROPEAN PATENT SPECIFICATION**

(45) Date of publication and mention of the grant of the patent:
**15.08.2018   Bulletin 2018/33**

(51) Int Cl.:
*C23C 14/34* (2006.01)       *C04B 35/56* (2006.01)
*H01J 37/34* (2006.01)       *C04B 35/64* (2006.01)
*C04B 35/645* (2006.01)       *C23C 14/35* (2006.01)
*C23C 14/06* (2006.01)

(21) Application number: **15770392.7**

(22) Date of filing: **13.03.2015**

(86) International application number:
**PCT/JP2015/057414**

(87) International publication number:
**WO 2015/146617 (01.10.2015 Gazette 2015/39)**

(54) **SPUTTERING TARGET COMPRISING TUNGSTEN CARBIDE OR TITANIUM CARBIDE**

SPUTTERING-TARGET MIT WOLFRAMCARBID ODER TITANCARBID

CIBLE DE PULVÉRISATION COMPRENANT DU CARBURE DE TUNGSTÈNE OU DU CARBURE DE TITANE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.03.2014   JP 2014064558**
**27.03.2014   JP 2014065284**

(43) Date of publication of application:
**10.08.2016   Bulletin 2016/32**

(73) Proprietor: **JX Nippon Mining & Metals Corporation**
**Tokyo 100-8164 (JP)**

(72) Inventors:
• **OHASHI Kazumasa**
**Kitaibaraki-shi**
**Ibaraki 319-1535 (JP)**
• **ODA Kunihiro**
**Kitaibaraki-shi**
**Ibaraki 319-1535 (JP)**

(74) Representative: **Cornford, James Robert**
**Forresters IP LLP**
**Skygarden**
**Erika-Mann-Strasse 11**
**80636 München (DE)**

(56) References cited:
**WO-A1-2013/065337       WO-A1-2013/129434**
**JP-A- H02 196 065       JP-A- H04 128 369**
**JP-A- S62 158 162       JP-A- 2003 027 221**
**JP-A- 2004 091 241       US-A- 4 731 116**
**US-A1- 2005 258 033**

• SHON,I.-J. ET AL.: 'Properties and rapid consolidation of ultra-hard tungsten carbide' JOURNAL OF ALLOYS AND COMPOUNDS vol. 489, no. 1, 2009, ISSN 0925-8388 pages L4 - L8, XP055225266
• LEE,J.-H. ET AL.: 'Defect-enhanced solid-state reaction behavior of shock-modified Ti+C powder mixture compacts' JOURNAL OF MATERIALS PROCESSING TECHNOLOGY vol. 85, 1999, pages 79 - 82, XP027414621

**Description**

TECHNICAL FIELD

The present invention relates to a sputtering target configured from tungsten carbide or titanium carbide which has superior workability and enables stable high speed deposition.

BACKGROUND ART

The sputtering method for forming films from metals, ceramics and other materials has been used in numerous fields such as electronics, corrosion resistant materials and ornaments, catalysts, as well as in the manufacture of cutting/polishing materials and abrasion-resistant materials. While the sputtering method itself is a well-known method in the foregoing fields, particularly in the electronics field, a sputtering target which is suitable for forming films of complex shapes or forming circuits is in demand.

In recent years, pursuant to the wiring width of semiconductor devices becoming refined, the design concept is changing to that of attempting to gain the surface area by causing the circuit to be a three-dimensional structure, and the film structure is increasingly complex. Under these circumstances, when forming various device structures via the etching of films, it is necessary to mask and protect the sections that are not etched, and carbide of tungsten (W) or titanium (Ti) shows promise for the use as such hard mask material by leveraging such characteristics as high hardness and chemical resistance.

The characteristics required in a hard mask material are also becoming more severe over generations as with other general wiring materials. Meanwhile, tungsten carbide or titanium carbide is difficult to be densified due to its high melting point. With tungsten carbide (WC) or titanium carbide (TiC) used in carbide tools, high densification and high molding performance are achieved by adding cobalt (Co) as a binder material in an amount of roughly 5 to 25 wt% (refer to Patent Document 1, Patent Document 2).

Nevertheless, when preparing tungsten carbide or titanium carbide as a material of sputtering target for use in producing a semiconductor device, a raw material having as high purity as possible is desired since impurities affect the electrical characteristics and cause the generation of particles during sputtering. Accordingly, when this kind of high purity material is desired, the assistance in high densification by an additive cannot be expected.

Meanwhile, a material having a high purity but having a low density and great variation in hardness will have inferior workability, and when performing finishing processing to the surface of the sputtering target, there may be variations in the surface roughness and it may cause generation of more particles. Accordingly, even if high purification is fulfilled, with a material such as tungsten carbide, it is extremely difficult to perform finishing processing to the surface of the sputtering target to achieve a surface texture having superior particle characteristics.

As a carbide-based sputtering target, Patent Document 3 discloses a target for sputtering configured from a sintered compact having SiC and a Ta compound as its main components. Moreover, Patent Document 4 discloses a target material formed from a tantalum carbide sintered compact. Moreover, Patent Document 5 describes forming a TaCN barrier layer using a TaC sputtering target.

[CITATION LIST]

[Patent Documents]

Patent Document 1: JP 2001-062623 A
Patent Document 2: JP 2006-026867 A
Patent Document 3: JP H06-220624 A
Patent Document 4: JP 2009-137789 A
Patent Document 5: JP 2003-100663 A

US4731116 discloses sputtering targets and a process for producing the same, comprising carbides and/or nitrides and/or borides of refractory metals.

## SUMMARY OF INVENTION

[Technical Problem]

An object of the present invention is to provide a sputtering target configured from tungsten carbide or titanium carbide, characterized in that the target can maintain a high purity level without the addition of other components in tungsten carbide or titanium carbide, has a high density and a uniform and high in-plane hardness, and enables stable high speed deposition and less generation of particles.

[Solution to Problem]

As a result of intense study in order to resolve the foregoing problems, the present inventors discovered that: it is possible to obtain a sputtering target configured from tungsten carbide or titanium carbide, characterized in that the target can maintain a high purity level and has a high density and a uniform and high hardness, by mixing and sintering raw material powders having a different grain size distribution; and thereby, it is possible to deposit a film with few particles stably at a high deposition rate.

Based on the foregoing discovery, the present invention provides a tungsten carbide sputtering target, a titanium carbide sputtering target and methods of producing the same, as claimed.

[Advantageous Effects of Invention]

The present invention can provide a sputtering target configured from tungsten carbide or titanium carbide, wherein the purity level of tungsten carbide or titanium carbide is maintained high and the target has a high density and a uniform and high hardness. Since it is thereby possible to improve the workability of the target configured from tungsten carbide or titanium carbide and obtain a favorable surface texture, the present invention yields a superior effect of being able to suppress the generation of particles. Furthermore, since high speed deposition is enabled, the present invention additionally yields a superior effect from the perspective of being able to improve the productivity.

## BRIEF DESCRIPTION OF DRAWINGS

[Fig. 1] This is a diagram showing the grain size distribution of the raw material powder (median size: 1 $\mu$m).
[Fig. 2] This is a diagram showing the grain size distribution of the raw material powder (median size: 4 $\mu$m).
[Fig. 3] This is a diagram showing the grain size distribution of the raw material powder (median size: 7 $\mu$m).
[Fig. 4] This is a diagram showing the grain size distribution of the mixture of raw material powders (double peaked distribution).

## DESCRIPTION OF EMBODIMENTS

In recent state-of-the-art semiconductor devices, the wiring width is being extremely refined, and the use of tungsten carbide or titanium carbide is being anticipated as the hard mask material for forming a complex film structure. And this kind of hard mask material is formed using a sputtering target configured from tungsten carbide or titanium carbide. Under these usage conditions, in addition to possessing characteristics such as high hardness and chemical resistance, it is necessary to reduce impurities that affect the semiconductor characteristics, and achieve high densification of the target (sintered compact) in order to obtain favorable sputtering characteristics.

Nevertheless, the high densification of tungsten carbide or titanium carbide is difficult due to its high melting point, and the addition of a binder or the like is also undesirable from the perspective of impurities. In light of the foregoing circumstances, as a result of conducting additional research and development, the present inventors discovered that close packing is possible by mixing two or more types of raw material powders (high purity products) having a different average grain size, and both high purification and high densification can be simultaneously achieved by sintering this mixed powder, which led to the devisal of the present invention.

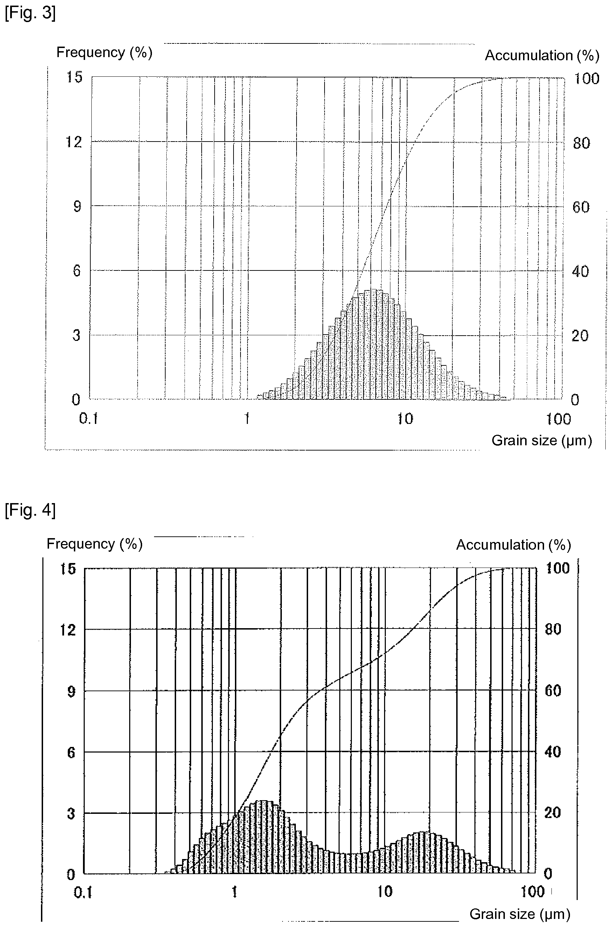

In order to achieve close packing, a raw material powder simply having a mixed grain size (large and small) with a broad grain size distribution width can be used instead; but in the foregoing case, the distribution of the fine powders will also be broad, and it causes an increase in the oxygen concentration of powders that are excessively fine and have a large surface area, and a deterioration in the particle characteristics. Moreover, when using a raw material powder which simply has a broad distribution width, it is difficult to increase the density of parts where the fine powders are aggregated, and variation in density tends to arise. Accordingly, the preferred configuration would be the one, in which the essential part having high density is formed using a solid powder with a relatively large grain size and the gaps between the solid powder grains are filled with a fine powder. In particular, it is desirable to mix at least two types of raw material powders (high purity products), one with a large grain size and another with a small grain size, both of which have a single peaked distribution and a narrow distribution width. When two types of raw material powders are mixed, the grain size distribution thereof will be a double peaked distribution as shown in Fig. 4. Note that the adjustment of the grain size distribution may be performed by using known methods such as sieving, and there is no particular limitation in the type of method that may be used. Moreover, various notations are used for indicating the grain size distribution, and the present invention uses a median size for the sake of convenience, but other notations may also be used.

In light of the above, the present invention is characterized in that two or more types of tungsten carbide or titanium carbide raw material powders having a different average grain size are mixed to prepare a mixed powder of which the grain size distribution has as many apexes as a number of types of raw material powders in the mixed powder, and the prepared mixed powder is sintered. A distribution having as many apexes as a number of types of raw material powders in the mixed powder means a double peaked distribution when two types of raw material powders are mixed, and a distribution with three apexes when three types of raw material powders are mixed, and, in both cases, the grain size of the respective raw material powders is reflected in each distribution. This also means that the grain size distribution of the raw material powders is narrow. This is because, with raw material powders having a broad grain size distribution, the difference in number of grains existing in the area near the peak grain size and in the periphery thereof is small, and the peaks (apexes) become unclear when several grain size distributions are superimposed. In the foregoing case, this will be synonymous with using a powder which simply has a broad grain size distribution, and induce variation in density due to the influence of oxidation caused by the fine grains or because close packing will not be effectively performed as a result of the gaps near the coarse grains being large.

The sputtering target configured from tungsten carbide or titanium carbide according to the present invention is now explained.

The sputtering target of the present invention is characterized in being configured from tungsten carbide or titanium carbide, and having a purity of 4N or higher and a density of 98% or higher. Since the target of the present invention is used for forming semiconductor devices, it is necessary to reduce the impurity content as much as possible, and the purity is preferably 4N or higher, and more preferably 4N5 or higher. Note that the purity described above is the purity excluding gas components. Moreover, since the particle characteristics will deteriorate when the density of the target is low, the density is preferably 98% or higher, and more preferably 99% or higher.

When the sputtering target of the present invention is configured from tungsten carbide, the hardness is HRA 90 or higher, and when the sputtering target of the present invention is configured from titanium carbide, the hardness is HV 2500 or higher, and the variation in hardness of the respective sputtering targets is within ±5%. When the hardness of the tungsten carbide target is less than HRA 90, or when the hardness of the titanium carbide target is less than HV 2500, such a target is undesirable since favorable machinability cannot be obtained and the intended final shape cannot be achieved upon performing final finishing processing of the target. Moreover, when the foregoing variation in hardness of the target exceeds ±5%, this is undesirable since it will increase the fluctuation of the cutting resistance of the target and shorten the life of the cutting tool, and it will not be possible to obtain a favorable, uniform surface texture.

HRA refers to the Rockwell hardness, and the A scale is used to notate the Rockwell hardness for high hardness materials such as tungsten carbide. A diamond cone having a tip radius of 0.2 mm and a tip angle of 120 degrees was used as the indenter, the surface (datum level) of the test piece was subject to plastic deformation by applying a basic load of 10 kg and a test load of 60 kg (70 kg in total), the load was reverted to the basic load of 10 kg, and the permanent depth h (mm) of the indentation from the datum level was measured. Subsequently, the HRA was obtained from the following calculation formula of the Rockwell hardness: HRA = 100 - 500 h.

Moreover, the variation in hardness is defined as follows in the present invention.

The hardness measurement test was performed at a total of 9 locations; i.e., the center of the sintered compact (disk shape), and, on each of radial lines extending in 4 directions from the center at intervals of 90 degrees, the intermediate point (1/2 R) and the position that is 10 mm inside the outer circumferential end (R). The variation in hardness was calculated using the following formula based on the average value of the foregoing 9 locations.

$$\text{Variation in hardness (\%)} = \{(\text{maximum value or minimum value} / \text{average value}) - 1\} \times 100$$

Moreover, HV refers to the Vickers hardness, and can be applied to high hardness materials such as titanium carbide. The Vickers hardness test was performed as follows; namely, forces were applied to an indenter (diamond in the form of a square-based pyramid) having an angle of 136° between the opposite faces toward a test piece to make an indentation, and the Vickers hardness was calculated from the indentation load, and the surface area obtained from the length of the diagonals left by the indenter. Note that this is prescribed in the Japanese Industrial Standards (JIS B7225, Z2244). Specifically, when the load is P[N] and the average length of the diagonals of the indentation is d[mm], the Vickers hardness is obtained from the following calculation formula: $HV = 0.18909 \times (P/d^2)$. Moreover, when the test load is p[kgf], the calculation formula of $HV = 1.8544 \times (p/d^2)$ is used.

The sputtering target of the present invention is further characterized in that machined finish surface roughness Ra is 1.0 $\mu$m or less, and surface roughness Ra after polishing processing is 0.2 $\mu$m or less. Here, the machined finish surface refers to a surface at the point of machined finish with an abrasive wheel using a surface grinding machine, and a surface after polishing processing refers to a surface that underwent surface finish using abrasive grains. The surface texture of this kind of target can suppress the generation of particles, as well as enables stable deposition.

[Examples]

The present invention is now explained in detail with reference to the Examples. These Examples are merely illustrative, and the present invention shall in no way be limited thereby. In other words, the present invention covers the other modes and modifications included in the technical concept of this invention.

[Tungsten carbide]

(Example 1-1)

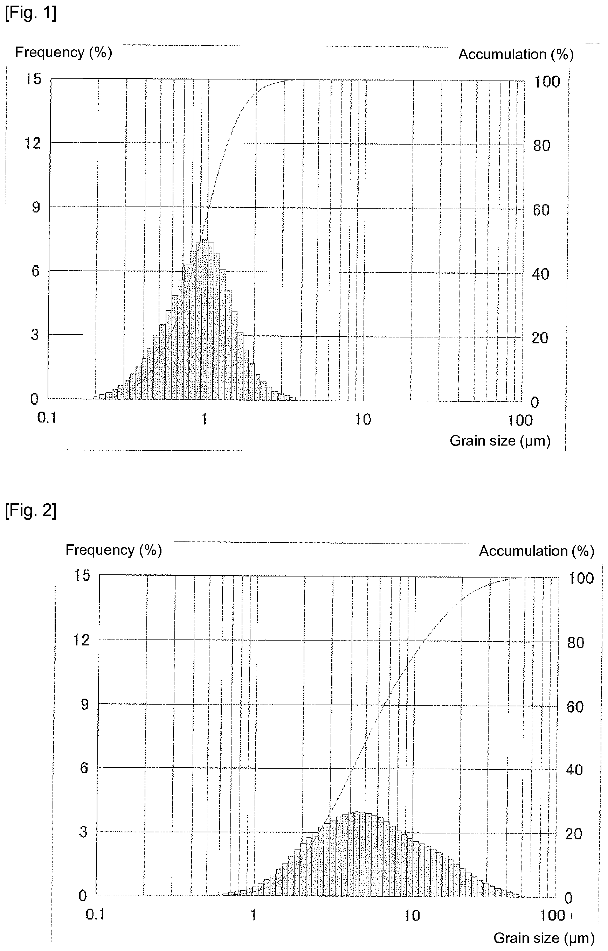

As raw material powders, a tungsten carbide powder (purity 4N) having a median size of 1 $\mu$m shown in Fig. 1 and a tungsten carbide powder (purity 4N) having a median size of 4 $\mu$m shown in Fig. 2 were prepared, and these powders were subject to argon replacement and mixed for 30 minutes in a ball mill. Subsequently, the mixed powder removed from the mill was filled in a carbon mold, and molded and sintered using a hot press device. The hot press conditions were as follows; specifically, vacuum atmosphere, rate of temperature increase of 300°C/hour, holding temperature of 1800°C, and holding time of 2 hours, and a pressure of 30 MPa was applied from the start of temperature increase to the end of holding. After the end of holding, the resultant product was naturally cooled as is in the chamber. Note that a total of two sintered compacts; specifically, one for measurement of physical properties and one for sputtering, were prepared.

Next, the hardness and density of the prepared sintered compact were analyzed. Consequently, the density was 99%, the hardness was HRA 95, and the variation in hardness was within ±3%. The density was measured based on the Archimedes method by destructively extracting samples of roughly 1 cm × 1 cm × 1 cm (thickness) from a total of 9 locations; i.e., the center of the sintered compact (disk shape), and, on each of radial lines extending in 4 directions from the center at intervals of 90 degrees, the intermediate point (1/2 R) and the outer circumferential end (R). Next, the other sintered compact was subject to machining and polishing processing and processed into a target. The surface roughness of the sintered compact was measured after each surface processing using a stylus-type surface roughness meter. Consequently, the machined finish surface roughness Ra was 0.32 $\mu$m, and the surface roughness Ra after polishing processing was 0.08 $\mu$m.

This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 13 particles. The results are shown in Table 1.

(Example 1-2)

As raw material powders, a tungsten carbide powder (purity 4N) having a median size of 2 $\mu$m and a tungsten carbide powder (purity 4N) having a median size of 4 $\mu$m shown in Fig. 2 were prepared, and these powders were subject to argon replacement and mixed for 30 minutes in a ball mill. Subsequently, the mixed powder removed from the mill was filled in a carbon mold, and molded and sintered using a hot press device. The hot press conditions were the same as those of Example 1-1. Note that a total of two sintered compacts; specifically, one for measurement of physical properties and one for sputtering, were prepared.

Next, the hardness and density of the prepared sintered compact were analyzed. Consequently, the density was 98.7%, the hardness was HRA 93, and the variation in hardness was within ±3.3%. The hardness and density were measured in the same manner as Example 1-1. Next, the other sintered compact was subject to machining and polishing processing and processed into a target. As a result of measuring the surface roughness of the sintered compact after each surface processing in the same manner as Example 1-1, the machined finish surface roughness Ra was 0.55 $\mu$m, and the surface roughness Ra after polishing processing was 0.12 $\mu$m.

This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 18 particles. The results are shown in Table 1.

(Example 1-3)

As raw material powders, a tungsten carbide powder (purity 4N) having a median size of 1 μm shown in Fig. 1 and a tungsten carbide powder (purity 4N) having a median size of 7 μm shown in Fig. 3 were prepared, and these powders were subject to argon replacement and mixed for 30 minutes in a ball mill. Subsequently, the mixed powder removed from the mill was filled in a carbon mold, and molded and sintered using a hot press device. The hot press conditions were the same as those of Example 1-1. Note that a total of two sintered compacts; specifically, one for measurement of physical properties and one for sputtering, were prepared.

Next, the hardness and density of the prepared sintered compact were analyzed. Consequently, the density was 98.3%, the hardness was HRA 91, and the variation in hardness was within ±4.2%. The hardness and density were measured in the same manner as Example 1-1. Next, the other sintered compact was subject to machining and polishing processing and processed into a target. As a result of measuring the surface roughness of the sintered compact after each surface processing in the same manner as Example 1-1, the machined finish surface roughness Ra was 0.86 μm, and the surface roughness Ra after polishing processing was 0.15 μm.

This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 19 particles. The results are shown in Table 1.

(Comparative Example 1-1)

As a raw material powder, a tungsten carbide powder (purity 4N) having a median size of 1 μm shown in Fig. 1 was prepared, and this powder was subject to argon replacement in a ball mill and subsequently filled in a carbon mold, and molded and sintered using a hot press device. The hot press conditions were the same as those of Example 1-1. Note that a total of two sintered compacts; specifically, one for measurement of physical properties and one for sputtering, were prepared.

Next, the hardness and density of the prepared sintered compact were analyzed. Consequently, the density was 97.8%, the hardness was HRA 95, and the variation in hardness was within ±6%. The hardness and density were measured in the same manner as Example 1-1. Next, the other sintered compact was subject to machining and polishing processing and processed into a target. As a result of measuring the surface roughness of the sintered compact after each surface processing in the same manner as Example 1-1, the machined finish surface roughness Ra and the surface roughness Ra after polishing processing were as given in table 1.

This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 25 particles. The results are shown in Table 1.

(Comparative Example 1-2)

As a raw material powder, a tungsten carbide powder (purity 4N) having a median size of 4 μm shown in Fig. 2 was prepared, and this powder was subject to argon replacement in a ball mill and subsequently filled in a carbon mold, and molded and sintered using a hot press device. The hot press conditions were the same as those of Example 1-1. Note that a total of two sintered compacts; specifically, one for measurement of physical properties and one for sputtering, were prepared.

Next, the hardness and density of the prepared sintered compact were analyzed. Consequently, the density was 97.5%, the hardness was HRA 93, and the variation in hardness was within ±7%. The hardness and density were measured in the same manner as Example 1-1. Next, the other sintered compact was subject to machining and polishing processing and processed into a target. As a result of measuring the surface roughness of the sintered compact after each surface processing in the same manner as Example 1-1, the machined finish surface roughness Ra was 0.98 μm, and the surface roughness Ra after polishing processing was 0.09 μm.

This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 58 particles. The results are shown in Table 1.

(Comparative Example 1-3)

As a raw material powder, a tungsten carbide powder (purity 4N) having a median size of 7 μm shown in Fig. 3 was prepared, and this powder was subject to argon replacement in a ball mill and subsequently filled in a carbon mold, and molded and sintered using a hot press device. The hot press conditions were the same as those of Example 1-1. Note that a total of two sintered compacts; specifically, one for measurement of physical properties and one for sputtering, were prepared.

Next, the hardness and density of the prepared sintered compact were analyzed. Consequently, the density was 97.2%, the hardness was HRA 91, and the variation in hardness was within ±8%. The hardness and density were measured in the same manner as Example 1-1. Next, the other sintered compact was subject to machining and polishing processing and processed into a target. As a result of measuring the surface roughness of the sintered compact after each surface processing in the same manner as Example 1-1, the machined finish surface roughness Ra was 1.25 μm, and the surface roughness Ra after polishing processing was 0.35 μm.

This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 134 particles. The results are shown in Table 1.

[Table 1]

| | Grain size of raw material powder (μm) | | Density (%) | Hardness HRA | Variation (%) | Surface roughness of machined surface (μm) | Surface roughness of polished surface (μm) | Number of particles |
|---|---|---|---|---|---|---|---|---|
| Example 1-1 | 1 | 4 | 99 | 95 | ±3 | 0.32 | 0.08 | 13 |
| Example 1-2 | 2 | 4 | 98.7 | 93 | ±3.3 | 0.55 | 0.12 | 18 |
| Example 1-3 | 1 | 7 | 98.3 | 91 | ±4.2 | 0.86 | 0.15 | 19 |
| Comparative Example 1-1 | 1 | - | 97.8 | 95 | ±6 | 0.75 | 0.13 | 25 |
| Comparative Example 1-2 | 4 | - | 97.5 | 93 | ±7 | 0.98 | 0.09 | 58 |
| Comparative Example 1-3 | 7 | - | 97.2 | 91 | ±8 | 1.25 | 0.35 | 134 |

[Titanium carbide]

(Example 2-1)

As raw material powders, a titanium carbide powder (purity 4N) having a median size of 1 μm shown in Fig. 1 and a titanium carbide powder (purity 4N) having a median size of 4 μm shown in Fig. 2 were prepared, and these powders were subject to argon replacement and mixed for 30 minutes in a ball mill. Subsequently, the mixed powder removed from the mill was filled in a carbon mold, and molded and sintered using a hot press device. The hot press conditions were as follows; specifically, vacuum atmosphere, rate of temperature increase of 300°C/hour, holding temperature of 1600°C, and holding time of 2 hours, and a pressure of 30 MPa was applied from the start of temperature increase to the end of holding. After the end of holding, the resultant product was naturally cooled as is in the chamber. Note that a total of two sintered compacts; specifically, one for measurement of physical properties and one for sputtering, were prepared.

Next, the hardness and density of the prepared sintered compact were analyzed. Consequently, the density was 99.2%, the hardness was HV 2920, and the variation in hardness was within ±3.3%. The density was measured based on the Archimedes method by destructively extracting samples of roughly 1 cm × 1 cm × 1 cm (thickness) from a total of 9 locations; i.e., the center of the sintered compact (disk shape), and, on each of radial lines extending in 4 directions from the center at intervals of 90 degrees, the intermediate point (1/2 R) and the outer circumferential end (R). Next, the other sintered compact was subject to machining and polishing processing and processed into a target.

The surface roughness of the sintered compact after each surface processing was measured using a stylus-type surface roughness meter. Consequently, the machined finish surface roughness Ra was 0.42 $\mu$m, and the surface roughness Ra after polishing processing was 0.09 $\mu$m.

This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 18 particles. The results are shown in Table 2.

(Example 2-2)

As raw material powders, a titanium carbide powder (purity 4N) having a median size of 2 $\mu$m and a titanium carbide powder (purity 4N) having a median size of 4 $\mu$m shown in Fig. 2 were prepared, and these powders were subject to argon replacement and mixed for 30 minutes in a ball mill. Subsequently, the mixed powder removed from the mill was filled in a carbon mold, and molded and sintered using a hot press device. The hot press conditions were the same as those of Example 2-1. Note that a total of two sintered compacts; specifically, one for measurement of physical properties and one for sputtering, were prepared. Next, the hardness and density of the prepared sintered compact were analyzed. The same analyzing method as Example 2-1 was used. Consequently, the density was 98.6%, the hardness was HV 2840, and the variation in hardness was within $\pm$3.8%.

Next, the other sintered compact was subject to machining and polishing processing and processed into a target. As a result of measuring the surface roughness of the sintered compact after each surface processing in the same manner as Example 2-1, the machined finish surface roughness Ra was 0.58 $\mu$m, and the surface roughness Ra after polishing processing was 0.12 $\mu$m. This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 19 particles.

(Example 2-3)

As raw material powders, a titanium carbide powder (purity 4N) having a median size of 1 $\mu$m shown in Fig. 1 and a titanium carbide powder (purity 4N) having a median size of 7 $\mu$m shown in Fig. 3 were prepared, and these powders were subject to argon replacement and mixed for 30 minutes in a ball mill. Subsequently, the mixed powder removed from the mill was filled in a carbon mold, and molded and sintered using a hot press device. The hot press conditions were the same as those of Example 2-1. Note that a total of two sintered compacts; specifically, one for measurement of physical properties and one for sputtering, were prepared. Next, the hardness and density of the prepared sintered compact were analyzed. The same analyzing method as Example 2-1 was used. Consequently, the density was 98.1%, the hardness was HV 2530, and the variation in hardness was within $\pm$4.8%.

Next, the other sintered compact was subject to machining and polishing processing and processed into a target. As a result of measuring the surface roughness of the sintered compact after each surface processing in the same manner as Example 2-1, the machined finish surface roughness Ra was 0.76 $\mu$m, and the surface roughness Ra after polishing processing was 0.16 $\mu$m. This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 24 particles.

(Comparative Example 2-1)

As a raw material powder, a titanium carbide powder (purity 4N) having a median size of 1 $\mu$m shown in Fig. 1 was prepared, and this powder was subject to argon replacement in a ball mill and subsequently filled in a carbon mold, and molded and sintered using a hot press device. The hot press conditions were the same as those of Example 2-1. Note that a total of two sintered compacts; specifically, one for measurement of physical properties and one for sputtering, were prepared.

Next, the hardness and density of the prepared sintered compact were analyzed. The same analyzing method as Example 2-1 was used. Consequently, the density was 97.5%, the hardness was HV 2850, and the variation in hardness was within $\pm$7.3%.

Next, the other sintered compact was subject to machining and polishing processing and processed into a target. As a result of measuring the surface roughness of the sintered compact after each surface processing in the same manner as Example 2-1, the machined finish surface roughness Ra was 0.77 $\mu$m, and the surface roughness Ra after polishing processing was 0.17 $\mu$m. This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 35 particles.

(Comparative Example 2-2)

As a raw material powder, a titanium carbide powder (purity 4N) having a median size of 4 $\mu$m shown in Fig. 2 was prepared, and this powder was subject to argon replacement in a ball mill and subsequently filled in a carbon mold, and molded and sintered using a hot press device. The hot press conditions were the same as those of Example 2-1. Note that a total of two sintered compacts; specifically, one for measurement of physical properties and one for sputtering, were prepared. Next, the hardness and density of the prepared sintered compact were analyzed. The same analyzing method as Example 2-1 was used. Consequently, the density was 97.3%, the hardness was HV 2480, and the variation in hardness was within $\pm9.5\%$.

Subsequently, the other sintered compact was subject to machining and polishing processing and processed into a target. As a result of measuring the surface roughness of the sintered compact after each surface processing in the same manner as Example 2-1, the machined finish surface roughness Ra was 0.99 $\mu$m, and the surface roughness Ra after polishing processing was 0.10 $\mu$m. This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 59 particles.

(Comparative Example 2-3)

As a raw material powder, a titanium carbide powder (purity 4N) having a median size of 7 $\mu$m shown in Fig. 3 was prepared, and this powder was subject to argon replacement in a ball mill and subsequently filled in a carbon mold, and molded and sintered using a hot press device. The hot press conditions were the same as those of Example 2-1. Note that a total of two sintered compacts; specifically, one for measurement of physical properties and one for sputtering, were prepared.

Next, the hardness and density of the prepared sintered compact were analyzed. The same analyzing method as Example 2-1 was used. Consequently, the density was 95.2%, the hardness was HV 2350, and the variation in hardness was within $\pm10.2\%$.

Next, the other sintered compact was subject to machining and polishing processing and processed into a target. As a result of measuring the surface roughness of the sintered compact after each surface processing in the same manner as Example 2-1, the machined finish surface roughness Ra was 1.15 $\mu$m, and the surface roughness Ra after polishing processing was 0.36 $\mu$m. This target was mounted in magnetron sputtering equipment (C-3010 sputtering system manufactured by Canon Anelva) and sputtered at an input power of 500 W, and deposition was performed on a silicon substrate having a 4-inch diameter for 20 seconds. The number of particles that became adhered to the substrate was measured using a particle counter. The number of particles in this case was 214 particles.

[Table 2]

| | Grain size of raw material powder ($\mu$m) | | Density (%) | Hardness Hv | Variation (%) | Surface roughness of machined surface ($\mu$m) | Surface roughness of polished surface ($\mu$m) | Number of particles |
|---|---|---|---|---|---|---|---|---|
| Example 2-1 | 1 | 4 | 99.2 | 2920 | $\pm3.3$ | 0.42 | 0.09 | 18 |
| Example 2-2 | 2 | 4 | 98.6 | 2840 | $\pm3.8$ | 0.58 | 0.12 | 19 |
| Example 2-3 | 1 | 7 | 98.1 | 2530 | $\pm4.8$ | 0.76 | 0.16 | 24 |
| Comparative Example 2-1 | 1 | - | 97.5 | 2850 | $\pm7.3$ | 0.77 | 0.17 | 35 |
| Comparative Example 2-2 | 4 | - | 97.3 | 2480 | $\pm9.5$ | 0.99 | 0.1 | 59 |
| Comparative Example 2-3 | 7 | - | 95.2 | 2350 | $\pm10.2$ | 1.15 | 0.36 | 214 |

INDUSTRIAL APPLICABILITY

The present invention can provide a sputtering target configured from tungsten carbide or titanium carbide, wherein the purity level of tungsten carbide or titanium carbide is maintained high and the target has a high density and a uniform and high hardness. Since it is thereby possible to improve the workability of the target and obtain a favorable surface texture, the present invention yields a superior effect of being able to suppress the generation of particles. The present invention is useful as a target that is suitable for use in the electronics field, particularly for forming hard masks that are used in the formation of films of complex shapes or formation of circuits.

**Claims**

1. A tungsten carbide sputtering target, having a purity of 4N or higher and a density of 98% or higher.

2. The tungsten carbide sputtering target according to claim 1, having a Rockwell hardness on the A scale (HRA) of 90 or higher using a diamond cone having a tip radius of 0.2 mm and a tip angle of 120 degrees as an indenter and applying a basic load of 10 kg and a test load of 60 kg (70 kg in total), and having a variation in hardness within ±5%.

3. The tungsten carbide sputtering target according to claim 1 or claim 2, wherein machined finish surface roughness Ra is 1.0 μm or less.

4. The tungsten carbide sputtering target according to any one of claims 1 to 3, wherein surface roughness Ra after polishing processing is 0.2 μm or less.

5. A method of producing a tungsten carbide sputtering target having a purity of 4N or higher and a density of 98% or higher, wherein two or more types of tungsten carbide raw material powders having a purity of 4N or higher and having a different average grain size are mixed to prepare a mixed powder of which the grain size distribution has as many apexes as a number of types of raw material powders in the mixed powder, and the prepared mixed powder is sintered.

6. The method of claim 5, further comprising subjecting the powders to argon replacement and mixing for 30 minutes in a ball mill.

7. The method of claim 5 or 6, wherein the sintering is performed using a hot press in a vacuum atmosphere with a rate of temperature increase of 300°C/hour, a holding temperature of 1800°C and holding time of 2 hours, with a pressure of 30 MPa applied from the start of temperature increase to the end of holding.

8. A titanium carbide sputtering target, having a purity of 4N or higher and a density of 98% or higher.

9. The titanium carbide sputtering target according to claim 8, having a Vickers hardness (HV) of 2500 or higher, such as prescribed in the Japanese Industrial Standards (JIS B7225, Z2244), specifically, when the load is P[N] and the average length of the diagonals of the indentation is d[mm], the Vickers hardness is obtained from the following calculation formula: HV = 0.18909 x (P/d<2>) and when the test load is p[kgf], the calculation formula of HV = 1.8544 x (p/d<2>) is used, and a variation in hardness within ±5%.

10. The titanium carbide sputtering target according to claim 8 or claim 9, wherein machined finish surface roughness Ra is 1.0 μm or less.

11. The titanium carbide sputtering target according to any one of claims 8 to 10, wherein surface roughness Ra after polishing processing is 0.2 μm or less.

12. A method of producing a titanium carbide sputtering target having a purity of 4N or higher and a density of 98% or higher, wherein two or more types of titanium carbide raw material powders having a purity of 4N or higher and having a different average grain size are mixed to prepare a mixed powder of which the grain size distribution has as many apexes as a number of types of raw material powders in the mixed powder, and the prepared mixed powder is sintered.

13. The method of claim 12, further comprising subjecting the powders to argon replacement and mixing for 30 minutes in a ball mill.

14. The method of claim 12 or 13, wherein the sintering is performed using a hot press in a vacuum atmosphere with a rate of temperature increase of 300°C/hour, a holding temperature of 1600°C and holding time of 2 hours, with a pressure of 30 MPa applied from the start of temperature increase to the end of holding.

**Patentansprüche**

1. Wolframcarbid-Sputtering-Target mit einer Reinheit von 4N oder höher und einer Dichte von 98 % oder höher.

2. Wolframcarbid-Sputtering-Target nach Anspruch 1 mit einer Rockwell-Härte auf der A-Skala (HRA) von 90 oder höher bei Verwendung eines Diamantkegels mit einem Spitzenradius von 0,2 mm und einem Spitzenwinkel von 120 Grad als Eindringkörper und Anwendung einer Grundlast von 10 kg und einer Prüflast von 60 kg (insgesamt 70 kg) und mit einer Variation der Härte innerhalb von ±5 %.

3. Wolframcarbid-Sputtering-Target nach Anspruch 1 oder Anspruch 2, worin die bearbeitete fertige Oberflächenrauheit Ra 1,0 μm oder weniger ist.

4. Wolframcarbid-Sputtering-Target nach einem der Ansprüche 1 bis 3, worin die Oberflächenrauheit Ra nach Polierbearbeitung 0,2 μm oder weniger ist.

5. Verfahren zur Herstellung eines Wolframcarbid-Sputtering-Targets mit einer Reinheit von 4N oder höher und einer Dichte von 98 % oder höher, worin zwei oder mehr Arten von Wolframcarbid-Rohstoffpulvern mit einer Reinheit von 4N oder höher und mit einer unterschiedlichen mittleren Korngröße gemischt werden, um ein gemischtes Pulver herzustellen, dessen Korngrößenverteilung so viele Scheitel wie eine Anzahl von Arten von Rohstoffpulvern im gemischten Pulver aufweist, und das hergestellte gemischte Pulver gesintert wird.

6. Verfahren nach Anspruch 5, ferner umfassend das Aussetzen der Pulver an Argonersatz und Mischen für 30 Minuten in einer Kugelmühle.

7. Verfahren nach Anspruch 5 oder 6, worin das Sintern mithilfe einer Heißpresse in einer Vakuumatmosphäre bei einer Temperaturzunahmerate von 300 °C/Stunde, einer Haltetemperatur von 1800 °C und einer Haltezeit von 2 Stunden durchgeführt wird, wobei ein Druck von 30 MPa vom Anfang der Temperaturzunahme bis zum Ende des Haltens angewandt wird.

8. Titancarbid-Sputtering-Target mit einer Reinheit von 4N oder höher und einer Dichte von 98 % oder höher.

9. Titancarbid-Sputtering-Target nach Anspruch 8 mit einer Vickers-Härte (HV) von 2500 oder höher, wie zum Beispiel in den japanischen Industrienormen (JIS B7225, Z2244) festgelegt, spezifisch, wenn die Last P [N] beträgt und die mittlere Länge der Diagonalen des Eindrucks d [mm] beträgt, die Vickers-Härte durch die folgende Berechnungsformel HV = 0,18909 x (P/d<2>) ermittelt wird und, wenn die Prüflast p [kgf] beträgt, die Berechnungsformel von HV = 1,8544 x (p/d<2>) verwendet wird, und einer Variation der Härte innerhalb von ±5 %.

10. Titancarbid-Sputtering-Target nach Anspruch 8 oder Anspruch 9, worin die bearbeitete fertige Oberflächenrauheit Ra 1,0 μm oder weniger ist.

11. Titancarbid-Sputtering-Target nach einem der Ansprüche 8 bis 10, worin die Oberflächenrauheit Ra nach Polierbearbeitung 0,2 μm oder weniger ist.

12. Verfahren zur Herstellung eines Titancarbid-Sputtering-Targets mit einer Reinheit von 4N oder höher und einer Dichte von 98 % oder höher, worin zwei oder mehr Arten von Titancarbid-Rohstoffpulvern mit einer Reinheit von 4N oder höher und mit einer unterschiedlichen mittleren Korngröße gemischt werden, um ein gemischtes Pulver herzustellen, dessen Korngrößenverteilung so viele Scheitel wie eine Anzahl von Arten von Rohstoffpulvern im gemischten Pulver aufweist, und das hergestellte gemischte Pulver gesintert wird.

13. Verfahren nach Anspruch 12, ferner umfassend das Aussetzen der Pulver an Argonersatz und Mischen für 30 Minuten in einer Kugelmühle.

**14.** Verfahren von Anspruch 12 oder 13, worin das Sintern mithilfe einer Heißpresse in einer Vakuumatmosphäre bei einer Temperaturzunahmerate von 300 °C/Stunde, einer Haltetemperatur von 1600 °C und einer Haltezeit von 2 Stunden durchgeführt wird, wobei ein Druck von 30 MPa vom Anfang der Temperaturzunahme bis zum Ende des Haltens angewandt wird.

**Revendications**

**1.** Une cible de pulvérisation en carbure de tungstène, ayant une pureté égale ou supérieure à 4N et une densité égale ou supérieure à 98%.

**2.** La cible de pulvérisation en carbure de tungstène selon la revendication 1, ayant une dureté Rockwell sur l'échelle A (HRA) égale ou supérieure à 90 en utilisant un cône de diamant ayant un rayon de pointe de 0,2 mm et un angle de pointe de 120 degrés en tant que pénétrateur et en appliquant une charge de base de 10 kg et une charge d'essai de 60 kg (70 kg en tout), et ayant une variation de dureté de $\pm 5\%$.

**3.** La cible de pulvérisation en carbure de tungstène selon la revendication 1 ou la revendication 2, dans laquelle la rugosité de surface en fini usiné Ra est égale ou inférieure à 1,0 $\mu$m.

**4.** La cible de pulvérisation en carbure de tungstène selon l'une quelconque des revendications 1 à 3, dans laquelle la rugosité de surface Ra après traitement de polissage est égale ou inférieure à 0,2 $\mu$m.

**5.** Un procédé de fabrication d'une cible de pulvérisation en carbure de tungstène ayant une pureté égale ou supérieure à 4N et une densité égale ou supérieure à 98%, dans lequel deux ou plus de deux types de poudres de matières premières de carbure de tungstène ayant une pureté égale ou supérieure à 4N et ayant une granulométrie différente sont mélangés pour préparer une poudre mélangée dont la distribution granulométrique a autant de sommets qu'un certain nombre de types de poudres de matières premières dans la poudre mélangée, et la poudre mélangée préparée est frittées.

**6.** Le procédé selon la revendication 5, consistant en outre à soumettre les poudres à un remplacement d'argon et à mélanger pendant 30 minutes dans un broyeur à boulets.

**7.** Le procédé selon la revendication 5 ou 6, dans lequel le frittage est effectué en utilisant une presse à chaud dans une atmosphère sous vide avec une vitesse d'augmentation de température de 300°C/heure, une température de maintien de 1800°C et un temps de maintien de 2 heures, avec une pression de 30 MPa appliquée depuis le début de l'augmentation de température jusqu'à la fin du maintien.

**8.** Une cible de pulvérisation en carbure de titane, ayant une pureté égale ou supérieure à 4N et une densité égale ou supérieure à 98%.

**9.** La cible de pulvérisation en carbure de titane selon la revendication 8, ayant une dureté Vickers (HV) égale ou supérieure à 2500, telle que définie dans les normes industrielles japonaises (JIS B7225, Z2244), spécifiquement, lorsque la charge est P[N] et que la longueur moyenne des diagonales de l'indentation est d[mm], la dureté Vickers est obtenue par la formule de calcul suivante : HV = 0,18909 x (P/d<2>) et lorsque la charge d'essai est p[kgf], la formule de calcul de HV = 1,8544 x (p/d<2>) est utilisée, et une variation de dureté de $\pm 5\%$.

**10.** La cible de pulvérisation en carbure de titane selon la revendication 8 ou la revendication 9, dans lequel la rugosité de surface en fini usiné Ra est égale ou inférieure à 0,1 $\mu$m.

**11.** La cible de pulvérisation en carbure de titane selon l'une quelconque des revendications 8 à 10, dans lequel la rugosité de surface Ra après traitement de polissage est égale ou inférieure à 0,2 $\mu$m.

**12.** Un procédé de fabrication d'une cible de pulvérisation en carbure de titane ayant une pureté égale ou supérieure à 4N et une densité égale ou supérieure à 98%, dans lequel deux ou plus de deux types de poudres de matières premières de carbure de titane ayant une pureté égale ou supérieure à 4N et ayant une granulométrie différente sont mélangés pour préparer une poudre mélangée dont la distribution granulométrique a autant de sommets qu'un certain nombre de types de poudres de matières premières dans la poudre mélangée, et la poudre mélangée préparée est frittée.

**13.** Le procédé selon la revendication 12, consistant en outre à soumettre les poudres à un remplacement d'argon et à mélanger pendant 30 minutes dans un broyeur à boulets.

**14.** Le procédé selon la revendication 12 ou 13, dans lequel le frittage est effectué en utilisant une presse à chaud dans une atmosphère sous vide avec une vitesse d'augmentation de température de 300°C/heure, une température de maintien de 1600°C et un temps de maintien de 2 heures, avec une pression de 30 MPa appliquée depuis le début de l'augmentation de température jusqu'à la fin du maintien.

[Fig. 1]

[Fig. 2]

[Fig. 3]

[Fig. 4]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001062623 A
- JP 2006026867 A
- JP H06220624 A

- JP 2009137789 A
- JP 2003100663 A
- US 4731116 A